Europäisches Patentamt

European Patent Office

Office européen des brevets

(19)

(11) Publication number: **0 138 639 B1**

(12) **EUROPEAN PATENT SPECIFICATION**

(45) Date of publication of patent specification: **22.01.92**  (51) Int. Cl.5: **G03B 41/00**

(21) Application number: **84401661.8**

(22) Date of filing: **13.08.84**

(54) Inspection method for mask pattern used in semiconductor device fabrication.

(30) Priority: **16.09.83 JP 170796/83**

(43) Date of publication of application:
**24.04.85 Bulletin  85/17**

(45) Publication of the grant of the patent:
**22.01.92 Bulletin  92/04**

(84) Designated Contracting States:
**DE FR GB**

(56) References cited:

**PATENT ABSTRACTS OF JAPAN, vol. 7, no. 119 (E-177)[1264], 24th May 1983; & JP-A-58 37 923**

**SOLID STATE TECHNOLOGY, vol. 21, no. 5, May 1978, pages 60-71, Port Washington, US; K. LEVY: "Automated equipment for 100% inspection of photomasks**

(73) Proprietor: **FUJITSU LIMITED**
**1015, Kamikodanaka Nakahara-ku**
**Kawasaki-shi Kanagawa 211(JP)**

(72) Inventor: **Kobayashi, Kenichi**
**34-3, Nagasaki 6-Chome Toshima-ku**
**Tokyo 171(JP)**

(74) Representative: **Descourtieux, Philippe et al**
**CABINET BEAU de LOMENIE 55 rue**
**d'Amsterdam**
**F-75008 Paris(FR)**

EP 0 138 639 B1

## Description

The present invention relates to an inspection method as claimed in claim 1 for a mask pattern on a photomask or a wafer used in the fabrication of a semiconductor device such as an integrated circuit (IC) or a large scale integrated circuit.

For the sake of convenience, the short word "IC" will be used as a "semiconductor integrated circuit device" in this disclosure hereinafter.

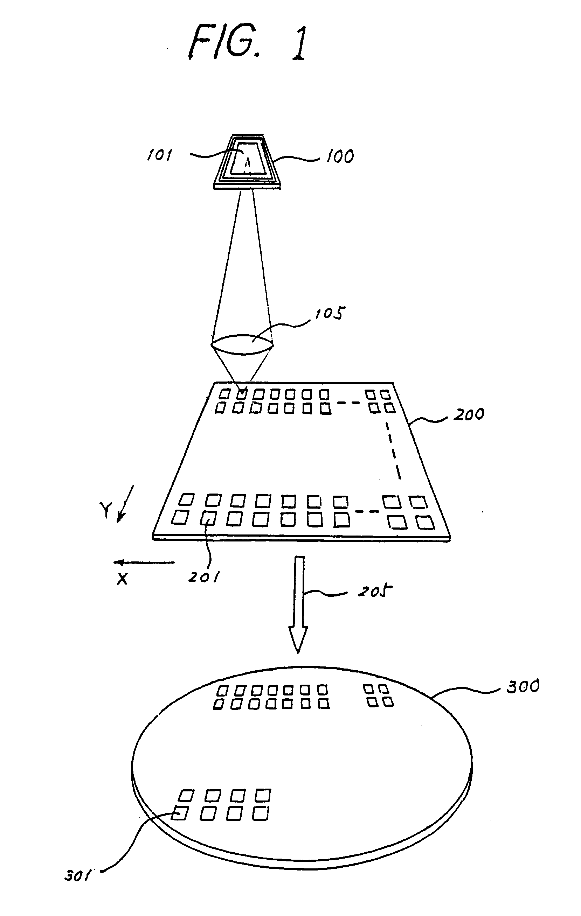

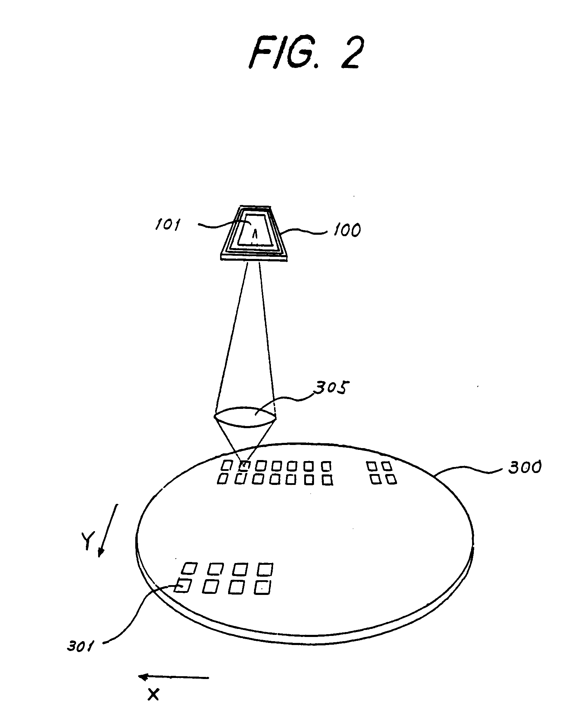

In the IC patterning process, there are two ways to print a mother pattern called a "reticle pattern" on the wafer. One is a way of applying a photomask, and the other is a way to print the reticle pattern directly on the wafer. Fig. 1 and 2 show these patterning processes in the IC fabrication; Fig.1 is for the former and Fig.2 is for the latter. In the way of Fig.1, the IC patterns of the photomask are made at first from the reticle pattern by a step and repeat printing method, and next the IC patterns of the photomask are directly printed on the wafer. On the other hand, in the way of Fig.2, the reticle pattern is directly printed on the wafer by a step and repeat method without applying any the photomask.

In Fig. 1 and 2, reference numeral 100 is a reticle, 200 is a photomask, and 300 is a wafer. The reticle 100 is made of a piece of silicate glass for example, on which a mother pattern is printed photographically from an original pattern. Reference numeral 101 is the mother pattern being called a "reticle pattern" here. As the reticle pattern 101 is the mother pattern, the pattern must be made with high accuracy, therefore the size of the pattern is made so large as 5 to 10 times of actual IC size. So, the reticle pattern is printed on the photomask or the wafer by an optical system having a reduction factor of the value between 1/10 and 1/5.

In Fig. 1, the reticle pattern 101 of the reticle 100 is exposed on a photographic plate fabricated on the surface of the photomask 200 by an optical system 105 having a reduction factor of the same value between 1/10 and 1/5. The exposure is made by a step and repeat procedure moving the photomask 200 in X and Y directions. Reference numeral 201 shows an individual IC pattern on the photomask 200, and its size is equal to that of an IC pattern on the wafer. Therefore, after fabricating the photomask, the photomask pattern having a plurality of the IC patterns is exposed on the surface of the wafer 300 in equal size; that is, the size of an IC pattern 301 on the wafer 300 is equal to that of the IC pattern 201 on the photomask 200. An arrow 205 shows this direct printing without reduction or magnification.

In Fig. 2, the reticle pattern of the reticle 100 is exposed on the surface of the wafer 300 by an optical system 305 having a reduction factor between 1/10 and 1/5 for the same reason as mentioned above in respect of Fig.1. The exposure for the printing is also made by the step and repeat procedure similarly to the case of Fig.1 moving the wafer 300 in the X and Y directions. Reference numeral 301 shows an individual IC pattern on the wafer 300.

The phrase "printed pattern" will be used hereinafter to designate the printed IC patterns on the photomask 200 or the wafer 300 in Fig.1, and on the wafer 300 in Fig.2, whereas, the phrase "mask pattern" will be used to designate for the IC patterns on the photomask 200 in Fig.1, and the reticle pattern 101 on the reticle 100 in Fig.2. Similarly, as the reticle pattern itself is made by printing an original pattern as mentioned before, the original pattern becomes a mask pattern and the reticle pattern 101 on the reticle 100 becomes a printed pattern in this case.

The exposing process for the printing is very important in the IC patterning process, and a defect cannot be allowed to exist. However, actually it becomes necessary to pay great attention to the fact that recently the probability for incorrect printing to occur has increased because the IC pattern has become very small and complicated to increase the IC packing density.

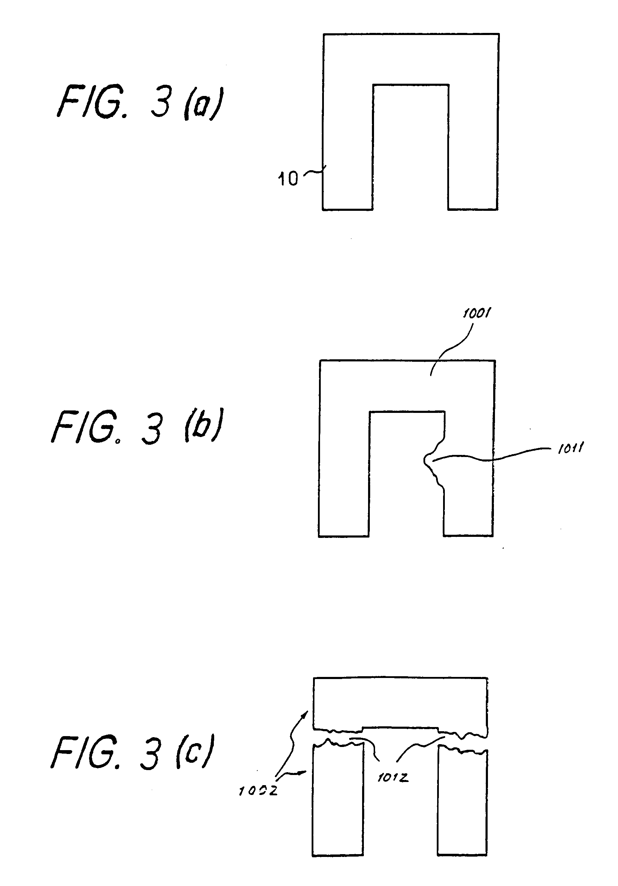

Fig. 3 shows examples of defects in the printed patterns with reference to the manufacture of a reticle pattern. Fig. 3 (a) shows an original pattern of the reticle pattern, Fig. 3 (b) shows an example of defect of the printed pattern (reticle pattern) on the reticle, and Fig. 3 (c) shows another example of the defect of the printed reticle pattern. In Fig. 3 (b), the printed pattern 1001 has an incorrect part 1011 which is mainly produced in a wrong developing process. In Fig. 3 (c), the printed pattern 1002 has a defective part 1012 which is mainly produced in a wrong exposing process.

The defects of these kinds will occur also in the patterning process of the wafer, and in each case, the defect occurs in the exposing or printing process presupposing that the mask pattern is correct. Therefore, it can be said that the defect can be avoided so long as sufficient attention is paid to the semiconductor patterning process. However, though sufficient attention is paid, if the mask pattern itself has a defect or the dust exists near by the mask pattern, it is not possible to avoid that an abnormality appears on the printed pattern.

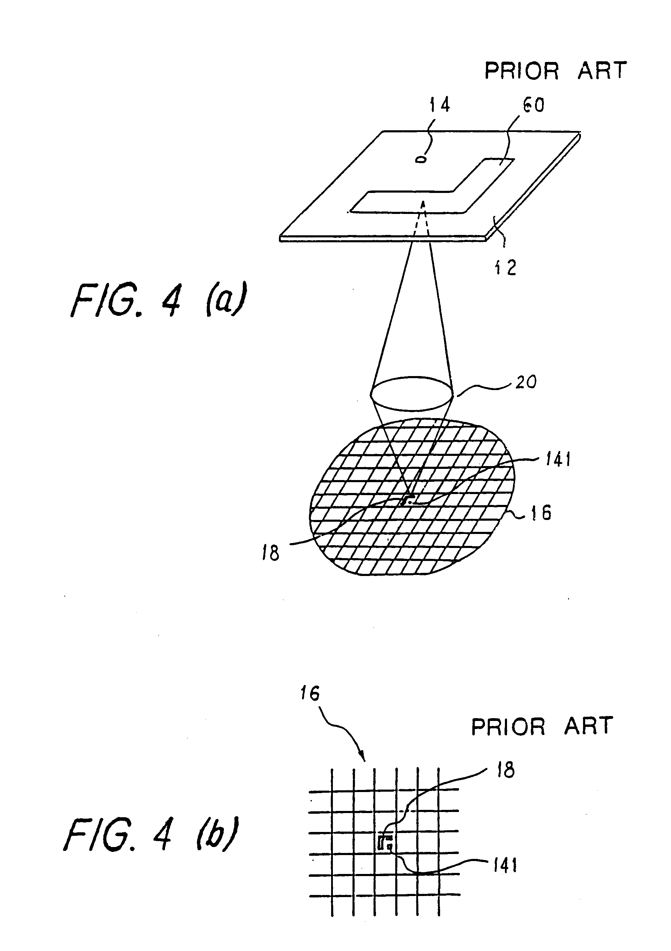

Fig. 4 illustrates this example showing the same patterning process as in Fig. 2; that is, the wafer is printed directly from the reticle pattern of the reticle. In the figure, reference numeral 12 is a reticle, 16 is a wafer, and 20 is an optical system having a reduction factor of the value between 1/10 and 1/5. On the reticle 12, reference numeral 60 is a reticle pattern, and 14 is dust. If such dust 14 exists on the reticle 12, a dust pattern 141 is printed on the wafer 16 beside a correct printed pattern 18 of the mask pattern 60. Fig. 4 (b) shows an expanded perspective illustration of the printed pattern on the wafer 16. Though it is not shown in the figures, such dust pattern 141 is printed on all of the patterns on the wafer 16.

If dust exists with the mask pattern or if a mask pattern itself has a defect, the whole patterning process ends in a failure. If such trouble occurs, the IC product suffers damage though every later process is correct. This gives great influence on the IC cost, because the IC patterning process also becomes more complicated as the packing density increases. So, the cause of the defect must be found out and removed as quickly as possible in the early stage of the patterning process.

Usually, the reticle pattern itself can be carefully inspected by various methods. Therefore, the probability that failure be caused by the defect of the reticle pattern itself can be rather low.

However, when the reticle pattern, which has been inspected and judged that it had no defect, is printed on the wafer, still the following problems are possible to occur.

Firstly, when the reticle is mounted on a projecting system as shown by the reticle 12 in Fig.4-(a) and dust happens to be stuck on the reticle, the image of the dust must be printed. Secondly, when the optical system has some defect, the reticle pattern cannot be correctly printed on the wafer.

Thus, though the reticle pattern itself is perfect, the above problems produced after the reticle inspection cause a defect to the actual optical image of the reticle pattern projected on the wafer, and the optical image has not been detected by the prior art reticle inspection.

Therefore, the object of the present invention is to improve the inspection method of the mask pattern so as to find out a defect of an actually exposed mask pattern caused by dust on the mask or defects of the optical system. Defects of this kind have not been able to be detected by the prior art inspection method such as a comparing method. Another object of the present invention is to save time and reduce cost in the IC production.

The present invention is performed by applying an image sensor on the stage on which an element such as a wafer or a photomask is mounted. An optical image of the mask pattern is projected on the image sensor which produces a video signal called a sensor video signal. This optical image of the mask pattern is almost identical to the actually exposed pattern on the wafer. Then, in order to judge whether the mask pattern is normal, the sensor video signal is compared with a data video signal which is a standard video signal taken from a designating database to fabricate the mask pattern. Said steps are processed before exposing said mask pattern on said fabricating object and said exposing is processed after said mask pattern has been judged to be normal.

Such a method, in which the almost actually exposed pattern can be inspected, permits to save a lot of time in the patterning process, especially in the event of a complicated IC pattern, and hence to reduce the cost of the IC product.

Fig. 1 is a perspective illustration showing a principle of a patterning process for semiconductor devices;

Fig. 2 is a perspective illustration showing a principle of another patterning process;

Fig. 3 shows an example of an original pattern and some kinds of defects on the printed pattern of the original pattern;

Fig. 3 (a) shows an example of the original pattern for the reticle mask pattern;

Fig. 3 (b) shows an example of a defect on the printed pattern of the original reticle pattern;

Fig. 3 (c) shows another example of a defect on the printed pattern of the original reticle pattern;

Fig. 4 shows a prior art fabrication system for semiconductor devices and the detail of the printed pattern in the system;

Fig. 4 (a) is a perspective illustration showing a semiconductor fabricating system having a reticle, an optical system, and a wafer;

Fig. 4 (b) shows a partially expanded view of the printed pattern;

Fig. 5 is a perspective illustration showing an embodiment of the present invention for a semiconductor fabricating system which includes an inspecting system;

Fig. 6 is a sectional view of a stage at A - A shown in Fig. 5; and

Fig. 7 is a block diagram of an inspecting system embodying the present invention relating to Fig. 5 and 6.

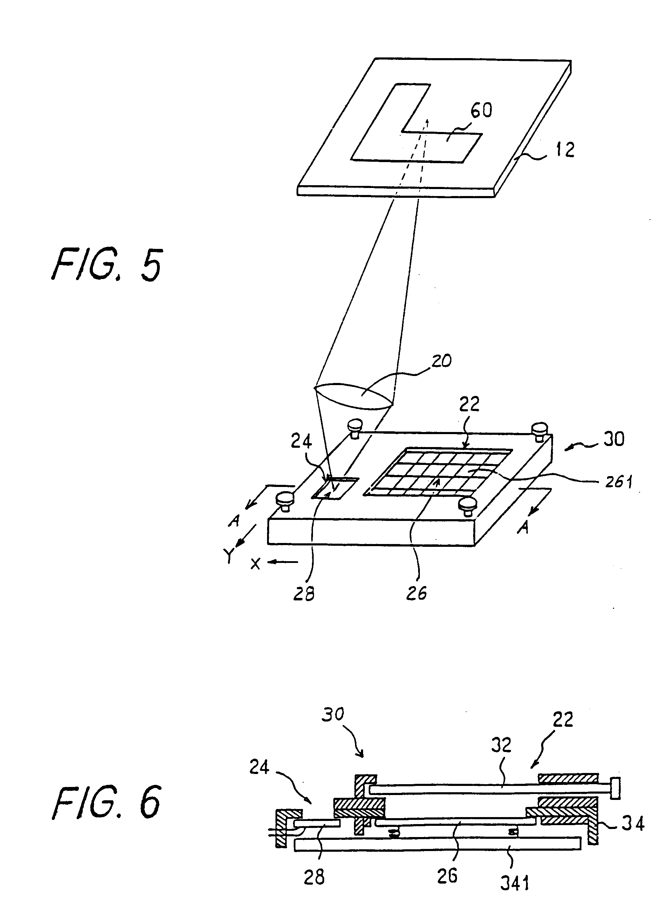

A preferred embodiment for the present invention will be disclosed with regard to Figs. 5, 6, and 7. The inspecting object of the present invention is a mask pattern, so it can be applied to any case as shown in Fig. 1 or 2. In this embodiment, the case of Fig. 2 will be disclosed; that is, the reticle pattern is printed directly on the wafer. Fig. 5 illustrates a semiconductor patterning system having a reticle, an optical system, and a stage.

In Fig. 5, reference numeral 12 is a reticle, 60 is a reticle pattern on the reticle 12, 30 is a stage for mounting a wafer, 26 is a wafer, 22 is a first window opened at the surface of the stage 30, the wafer 26 being mounted in the window 22, 24 is a second window opened beside the first window 22 and in which an image sensor 28 is mounted, and 20 is an optical system by which an optical image of the reticle pattern 60 is exposed and printed on the wafer 26 and also projected on the image sensor 28 switched by the operator. The optical system 20 mainly serves to expose and print the reticle pattern 60 on the wafer 26 so that each printed IC pattern is placed in a respective block of a checked pattern 261 by moving the stage 30 sequentially. Usually the optical system 20 has a reduction factor between 1/10 and 1/5. In this system, additional function is provided to inspect the optical image of the reticle pattern 60 before exposing it on the wafer 26. The inspection is done by projecting the optical image toward the image sensor 28 shifting the stage 30. This application of the image sensor 28 is a point of the present invention. The reticle 12, the optical system 20 and the stage 30 are installed in the airtight case (not shown) so that the mask pattern and wafer can be kept dust free.

In Fig. 6, the same reference numerals designate the same objects as in Fig. 5, and 34 is a case of the stage, 341 is a bottom plate which supports the wafer 26 to the case 34 pushing up the wafer 26 from the bottom, and 32 is a sliding shutter to protect the wafer 26 from the exposure of the light during the inspection by the image sensor.

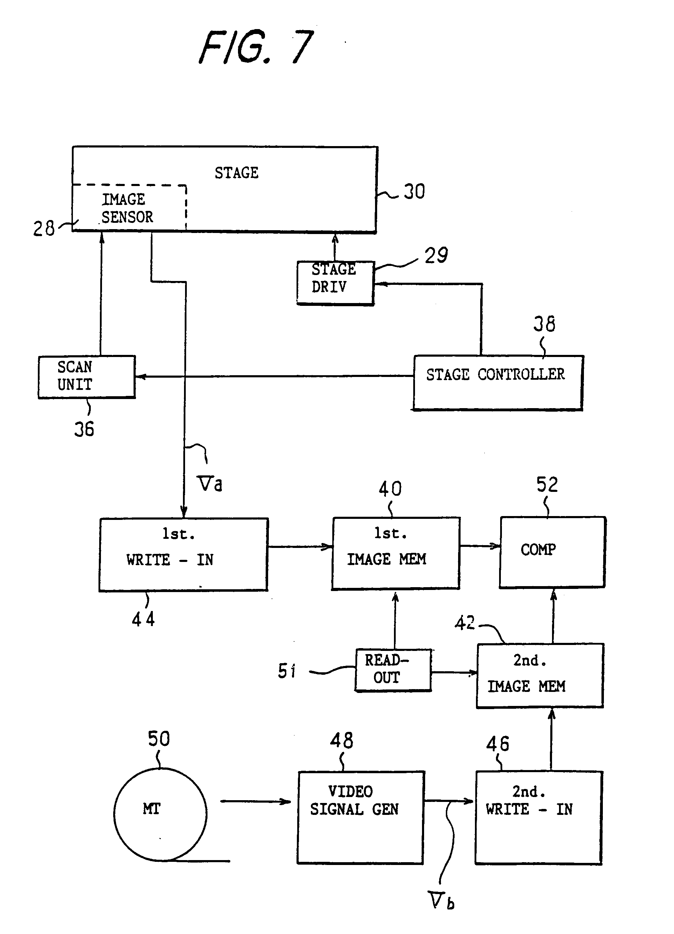

Fig. 7 shows a block diagram for a control system for the inspection system by the present invention. In the figure, the reference numerals which are the same as in Fig. 5 or 6 designate respectively the same objects, and 29 is a stage driver which drives the stage 30 in X or Y direction (see Fig.5), 36 is a scanning unit to switch sequentially the multi-elements of the imaging sensor 28 to convert the optical image corresponding to the multi-elements into electric signals, 38 is a stage controller which controls the scanning of the stage 30 and the scanning unit 36, $V_a$ shows a sensor video signal which is the output signal of the image sensor 28, 44 is a first write-in unit which writes the sensor video signal $V_a$ into a first image memory 40, 50 is a magnetic tape (MT) in which the designing data to fabricate the IC pattern are stored, 48 is a video signal generator, $V_b$ shows a data video signal, 46 is a second write-in unit, 42 is a second image memory, 51 is a read-out unit which controls the first memory 40 and the second memory 42 to read out the memorized signal and send it to a comparator 52, and 52 is the comparator in which the signal from the actual reticle pattern is compared with the signal from the standard data stored in the magnetic tape.

The operation of the embodiment is as follows. At first, the preparation of the exposure is done by mounting the wafer 26 on the stage 30 as shown in Fig. 6 and installing the reticle 12 as shown in Fig. 5. When the preparation has been made, in the operation of the prior art inspection, an exposing procedure is advanced; namely, the wafer 26 is brought by moving the stage so that the mask pattern 60 is exposed on a respective position of the wafer 26 by the step and repeat process, then each IC pattern is printed in each square (reference numeral 261 in Fig. 5) that corresponds to each chip of the IC as shown in Fig. 5. However, in the present invention, mask pattern 60 is first projected on the second window 24 before beginning the exposing process on the wafer 26. The optical image of the reticle pattern 60 projected on the second window 24 is scanned by the image sensor 28 converting to a train of video signals which is called herein a sensor video signal $V_a$. The sensor video signal $V_a$ is memorized sequentially in the first image memory 40 through the first writing unit 44, and therefore, the memorized video signal includes a signal of a defect or dust if they exist on the mask pattern 60 or on the reticle 12.

At the same time, designing data of the reticle pattern 60 stored in the MT 50 are read out and converted into the data video signal $V_b$, and memorized in the second image memory 42. The data video signal $V_b$ stored in the second image memory 42 is used as a standard signal to inspect the sensor video signal $V_a$ stored in the first image memory 40. Both video signals $V_a$ and $V_b$ are read out from the image memories 40 and 42 respectively and sent to the comparator 52 by the control of the read-out unit 51, and the inspection can be made by comparator 52 comparing the sensor video signal $V_a$ with the data video signal $V_b$. As the mask pattern 60 was made by an original pattern which was made by the design data, the sensor video signal $V_a$ must be equal to the data video signal $V_b$. If the sensor video signal $V_a$ had a defect which might be caused by failure in the patterning process for the mask pattern 60, or dust existing on the reticle 12, the comparator 52 detects the abnormality.

There are several possible kinds of image sensor 28. For example, a two-dimensional image sensor is applicable as the image sensor. The two-dimensional image sensor consists of two-dimensional multi-elements of the sensor. In this case, the size of the sensor is equal to the size of a single block of the check pattern 261 in Fig. 5; it is also equal to the size of the one IC chip pattern to be printed on the wafer 26. Therefore, when the optical image of the reticle pattern 60 is projected on the image sensor, the sensor video signal $V_a$ can be provided simultaneously without scanning the stage 30. Instead of this, a one-dimensional image sensor (a line sensor) also can be applied. This sensor consists of the multi-elements arranged in a line corresponding the either side of the rectangular reticle pattern 60. The sensor video

signal $V_a$ along the line is simultaneously provided. For example, if the direction of the sensors is aligned in X direction, the two-dimensional video signal can be obtained by mechanically scanning the stage 30 in Y direction. Fig. 7 shows the case which uses a one-dimensional image sensor. In this case, the sensor video signal $V_a$ must be synchronized with the scanning (switching) of the scanning unit 36 and the scanning of the stage 30, and this synchronization can be made by the scanning unit 36 and the stage driver 29 controlled by the control signals from the stage controller 38.

Further, instead of the optical system 20 in Fig. 5, another type of optical system can be used to project the reticle pattern 60 on the image sensor 28, apart from the optical system for printing the wafer. And the optical image of the reticle pattern on the image sensor might be enlarged with respect to the exposed image on the wafer. This system is effective to satisfy the resolution of the image sensor when the mask pattern is too much complicated and requires many picture elements.

The video signal generator 48 is required to convert the form of the design data in the MT 50 into the form of the data video signal $V_b$ to compare easily the sensor video signal $V_a$ with the designing data. Because, the data stored in the MT 50 generally has a vector form, therefore, the data is required to convert to the form of the sensor video signal $V_a$.

The first image memory 40 and the second image memory 42 each have memory cells. The amount of the memory cells is defined by the amount of the picture elements of the mask pattern which is also defined by the required resolution with respect to the IC pattern. Considering the above, if the mask pattern can be divided to N lines and M picture elements per each line, the memory cells also can be arranged N lines and M cells per each line, so that the total data capacity of each image memory becomes N x M bits.

The resolution of the optical system 20 is also defined by the resolution of the IC pattern. Therefore, it is not necessary to pay attention to dust when the dust is so tiny that it can not be resolved by the optical system 20.

In the above disclosure the description has been done with respect to the case of printing the reticle pattern directly on the wafer, but it will be clear that the process described above can be applied to the case using a photomask.

In any case the pattern checking method of the present invention is performed right before actually exposing the printing pattern on the wafer. Therefore it is very effective to decrease the failure due to the defect of the reticle pattern. It is very effective to increase the yield and decrease the manufacturing cost of ICs. And the disclosure has been done for the IC fabrication, but it will be clear that the process can be applied to any of semiconductor device manufacturing.

The above embodiment has disclosed the inspection which was performed right before actually exposing the printing pattern from the reticle on the wafer, however similar effect can be obtained by applying the present invention to an optical image of the mask pattern right before exposing the mask pattern from the reticle on the photomask and right before exposing the mask pattern from the photomask on the wafer.

## Claims

1. An inspection method for a mask pattern used in a semiconductor fabrication applying an optical system (20) by which said mask pattern (60) is exposed on a fabricating object to print said mask pattern, characterized in that it comprises the steps of:

   projecting an optical image of said mask pattern (60) on an image sensor (28) provided on a stage (30) on which said fabricating object (26) is mounted, said image sensor (28) converting said optical image to a sensor video signal ($V_a$); and

   judging whether said mask pattern is normal by comparing said sensor video signal ($V_a$) with a data video signal ($V_b$) taken from designating data having been used in fabricating said mask pattern (60),

   and that said steps are processed before exposing said mask pattern (60) on said fabricating object (26) and said exposing is processed after said mask pattern has been judged to be normal.

2. The inspection method according to claim 1, characterized in that said mask pattern comprises a mask pattern (60) on a reticle (12).

3. The inspection method according to claim 1, characterized in that said mask pattern comprises a single pattern (60).

4. The inspection method according to claim 3, characterized in that said single mask pattern (60) comprises the mask pattern on a reticle (12).

5. The inspection method according to claim 1, characterized in that said mask pattern comprises a plurality of patterns each having a same shape and size.

6. The inspection method according to claim 5, characterized in that said plurality of said mask patterns comprise the reticle patterns on a reticle.

7. The inspection method according to claim 1, characterized in that said fabricating object comprises a semiconductor wafer (26) to be fabricated.

8. The inspection method according to claim 1, characterized in that said fabricating object comprises a photomask (200) to be fabricated.

9. The inspection method according to claim 1, characterized in that said optical system comprises a single optical system (20) by which said optical image of said mask pattern is projected on either said fabricating object (26) or said image sensor (28) by means of a reducing projection.

10. The inspection method according to claim 1, characterized in that said optical system comprises different optical systems: one being for said fabricating object and the other being for said image sensor.

11. The inspection method according to claim 10, characterized in that said optical system for said image sensor comprises a means for having smaller reduction factor than a reduction factor of said optical system for said fabricating object.

12. The inspection method according to claim 1, characterized in that said image sensor (28) comprises a two-dimensional image sensor having a plurality of sensor elements arranged in a whole image plane which simultaneously converts said optical image of said mask pattern to said sensor video signal ($V_a$).

13. The inspection method according to claim 1, characterized in that said image sensor (28) comprises a one-dimensional image sensor having a plurality of sensor elements arranged on a line parallel to one side of said optical image of said mask pattern, which converts said optical image of said mask pattern to said sensor video signal ($V_a$) by mechanically scanning said stage (30) in a lateral direction to the line of sensor arrangement.

14. The inspection method according to claim 1, characterized in that a comparator (52) is used to compare said sensor video signal ($V_a$) and said data video signal ($V_b$) by reading out the data of a first image memory (40) in which the data of said sensor video signal ($V_a$) are written

and the data of a second image memory (42) in which the data of said data video signal ($V_b$) are written.

## Revendications

1. Procédé d'inspection pour motif de masque utilisé dans la fabrication d'un semiconducteur appliquant un système optique (20) par lequel ledit motif de masque (60) est exposé sur un objet de fabrication en vue du tirage dudit motif de masque, caractérisé en ce qu'il comprend les opérations suivantes :

   projeter une image optique dudit motif de masque (60) sur un capteur d'image (28) prévu sur une platine (30) sur laquelle ledit objet de fabrication (26) est monté, ledit capteur d'image (28) convertissant ladite image optique en un signal vidéo de capteur ($V_a$) ; et

   déterminer si le motif de masque est ou non normal en comparant ledit signal vidéo de capteur ($V_a$) avec un signal vidéo de données ($V_b$) qui est extrait des données de conception ayant été utilisées dans la fabrication dudit motif de masque (60),

   et en ce que lesdites opérations sont effectuées avant l'exposition dudit motif de masque (60) sur ledit objet de fabrication (26) et ladite exposition est effectuée après que ledit motif de masque a été déterminé comme étant normal.

2. Procédé d'inspection selon la revendication 1, caractérisé en ce que ledit motif de masque comprend un motif de masque (60) sur un réticule (12).

3. Procédé d'inspection selon la revendication 1, caractérisé en ce que ledit motif de masque comprend un unique motif (60).

4. Procédé d'inspection selon la revendication 3, caractérisé en ce que ledit unique motif de masque (60) comprend le motif de masque sur un réticule (12).

5. Procédé d'inspection selon la revendication 1, caractérisé en ce que ledit motif de masque comprend une pluralité de motifs ayant chacun une même forme et une même taille.

6. Procédé d'inspection selon la revendication 5, caractérisé en ce que ladite pluralité desdits motifs de masque comprend les motifs de réticule sur un réticule.

7. Procédé d'inspection selon la revendication 1, caractérisé en ce que ledit objet de fabrication comprend une pastille semiconductrice (26) à fabriquer.

8. Procédé d'inspection selon la revendication 1, caractérisé en ce que ledit objet de fabrication comprend un photomasque (200) à fabriquer.

9. Procédé d'inspection selon la revendication 1, caractérisé en ce que ledit système optique comprend un unique système optique (20) par lequel ladite image optique dudit motif de masque est projetée ou bien sur ledit objet de fabrication (26) ou bien sur ledit capteur d'image (28) par l'intermédiaire d'une projection réductrice.

10. Procédé d'inspection selon la revendication 1, caractérisé en ce que ledit système optique comprend différents systèmes optiques : un étant associé audit objet de fabrication et l'autre l'étant audit capteur d'image.

11. Procédé d'inspection selon la revendication 10, caractérisé en ce que ledit système optique associé audit capteur d'image comprend un moyen permettant d'avoir un facteur de réduction plus petit que le facteur de réduction dudit système optique associé audit objet de fabrication.

12. Procédé d'inspection selon la revendication 1, caractérisé en ce que ledit capteur d'image (28) comprend un capteur d'image à deux dimensions possédant une pluralité d'éléments de capteur disposés dans un plan d'image complet qui convertit simultanément ladite image optique dudit motif de masque en ledit signal vidéo de capteur ($V_a$).

13. Procédé d'inspection selon la revendication 1, caractérisé en ce que ledit capteur d'image (28) comprend un capteur d'image à une dimension possédant une pluralité d'éléments de capteur disposés sur une ligne parallèle à un côté de ladite image optique dudit motif de masque, qui convertit ladite image optique dudit motif de masque en ledit signal vidéo de capteur ($V_a$) par balayage mécanique de ladite platine (30) suivant une direction perpendiculaire à la ligne de disposition du capteur.

14. Procédé d'inspection selon la revendication 1, caractérisé en ce qu'un comparateur (52) est utilisé, qui compare ledit signal vidéo de capteur ($V_a$) et ledit signal vidéo de données ($V_b$) en lisant les données d'une première mémoire d'image (40) dans laquelle les données dudit signal vidéo de capteur ($V_a$) sont écrites et les données d'une deuxième mémoire d'image (42) dans laquelle les données dudit signal vidéo de données ($V_b$) sont écrites.

**Patentansprüche**

1. Inspektionsverfahren für ein Maskenmuster, das bei der Halbleiterherstellung unter Anwendung eines optischen Systems (20) verwendet wird, durch das das Maskenmuster (60) auf ein Fertigungsteil belichtet wird, um das Maskenmusters zu drucken, dadurch gekennzeichnet, daß es folgende Schritte enthält:

Projizieren eines optischen Bildes des Maskenmusters (60) auf einen Bildsensor (28), der auf einer Bühne (30), auf der das Fertigungsteil (26) angebracht ist, vorgesehen ist, welcher Bildsensor (28) das optische Bild in ein Sensorvideosignal ($V_a$) umwandelt; und

Beurteilen, ob das Maskenmuster normal ist, durch Vergleichen des Sensorvideosignales ($V_a$) mit einem Datenvideosignal ($V_b$), das aus spezifizierenden Daten, die bei der Herstellung des Maskenmusters (60) verwendet wurden, erhalten wird; und

dadurch, daß diese Schritte durchgeführt werden, bevor das Maskenmuster (60) auf das Fertigungsteil (26) belichtet wird, und daß die Belichtung durchgeführt wird, nachdem das Maskenmuster für normal beurteilt worden ist.

2. Inspektionsverfahren nach Anspruch 1, dadurch gekennzeichnet, daß das Maskenmuster ein Maskenmuster (60) auf einer Strichplatte (12) umfaßt.

3. Inspektionsverfahren nach Anspruch 1, dadurch gekennzeichnet, daß das Maskenmuster ein einzelnes Muster (60) umfaßt.

4. Inspektionsverfahren nach Anspruch 3, dadurch gekennzeichnet, daß das einzelne Maskenmuster (60) das Maskenmuster auf einer Strichplatte (12) umfaßt.

5. Inspektionsverfahren nach Anspruch 1, dadurch gekennzeichnet, daß das Maskenmuster eine Mehrzahl von Mustern umfaßt, von denen jedes gleiche Form und Größe hat.

6. Inspektionsverfahren nach Anspruch 5, dadurch gekennzeichnet, daß die Vielzahl der Maskenmuster die Strichplattenmuster auf einer Strichplatte umfassen.

7. Inspektionsverfahren nach Anspruch 1, dadurch gekennzeichnet, daß das Fertigungsteil einen zu fertigenden Halbleiter-Wafer (26) umfaßt.

**8.** Inspektionsverfahren nach Anspruch 1, dadurch gekennzeichnet, daß das Fertigungsteil eine zu fertigende Fotomaske (200) umfaßt.

**9.** Inspektionsverfahren nach Anspruch 1, dadurch gekennzeichnet, daß das optische System ein einziges optisches System (20) umfaßt, mit dem das optische Bild des Maskenmusters mit Hilfe einer verkleinernden Projektion entweder auf das Fertigungsteil (26) oder auf den Bildsensor (28) projiziert wird.

**10.** Inspektionsverfahren nach Anspruch 1, dadurch gekennzeichnet, daß das optische System unterschiedliche optische Systeme umfaßt: eines für das Fertigungsteil und das andere für den Bildsensor.

**11.** Inspektionsverfahren nach Anspruch 10, dadurch gekennzeichnet, daß das optische System für den Bildsensor eine Einrichtung zur Erzielung eines geringeren Verkleinerungsfaktors als ein Verkleinerungsfaktor des optischen Systems für das Fertigungsteil umfaßt.

**12.** Inspektionsverfahren nach Anspruch 1, dadurch gekennzeichnet, daß der Bildsensor (28) einen zweidimensionalen Bildsensor umfaßt, der eine Vielzahl von Sensorelementen hat, die in einer ganzen Bildebene angeordnet sind, der gleichzeitig das optische Bild des Maskenmusters in das Sensorvideosignal ($V_a$) umwandelt.

**13.** Inspektionsverfahren nach Anspruch 1, dadurch gekennzeichnet, daß der Bildsensor (28) einen eindimensionalen Bildsensor umfaßt, mit einer Vielzahl von Sensorelementen, die auf einer Linie parallel zu einer Seite des optischen Bildes des Maskenmusters angeordnet sind, der das optische Bild des Maskenmusters in das Sensorvideosignal ($V_b$) umwandelt, durch mechanisches Abtasten der Bühne (30) in einer Richtung seitlich zu der Linie der Sensoranordnung.

**14.** Inspektionsverfahren nach Anspruch 1, dadurch gekennzeichnet, daß ein Komparator (52) benutzt wird zum Vergleichen des Sensorvideosignales ($V_a$) und des Datenvideosignales ($V_b$) durch Auslesen der Daten aus einem ersten Bildspeicher (40), in dem die Daten des Sensorvideosignales ($V_a$) geschrieben sind, und der Daten eines zweiten Bildspeichers (42), in dem die Daten des Datenvideosignals ($V_b$) geschrieben sind.

## FIG. 1

# FIG. 2

FIG. 3 (a)

FIG. 3 (b)

FIG. 3 (c)

PRIOR ART

FIG. 4 (a)

PRIOR ART

FIG. 4 (b)

FIG. 5

FIG. 6

# FIG. 7